# EUROPÄISCHE PATENTSCHRIFT

(11) **EP 0 854 585 B1**
(45) Veröffentlichungstag und Bekanntmachung des Hinweises auf die Patenterteilung: **26.05.2004**
(21) Anmeldenummer: 97120838.4
(22) Anmeldetag: 27.11.1997
(51) Int. Cl.: H04B 1/56, H04B 1/40

(54) **Sende- und Empfangsanordnung für Hochfrequenzsignale**
RF transceiver
Emetteur-récepteur de signaux radiofréquences

(30) Priorität: 21.01.1997 DE 19701910
(43) Veröffentlichungstag der Anmeldung: 22.07.1998
(73) Patentinhaber: Infineon Technologies AG, 81669 München (DE)
(72) Erfinder: Thomas, Volker, Dr., 81245 München (DE); Beyer, Stefan, 86415 Mering (DE); Heinen, Stefan, Dr., 47802 Krefeld (DE)
(74) Vertreter: Reinhard - Skuhra - Weise & Partner

(56) Entgegenhaltungen:
- DE-A- 19 502 111
- US-A- 5 515 364
- US-A- 5 574 986

## Beschreibung

Die Erfindung betrifft eine Sende- und Empfangsanordnung für Hochfrequenzsignale nach dem Oberbegriff des Patentanspruchs 1.

In zeitschlitzgesteuerten Sendeanordnungen bei sogenanntem TDMA-(Time Division Multiple Access)-Betrieb wird nur während eines Zeitschlitzes ein Signal abgestrahlt, während der übrigen Zeit unterbleibt die Signalabstrahlung. Zur Erzeugung des sendeträgersignals dient ein Phasenregelkreis, der unmittelbar vor dem Zeitschlitz aktiviert wird und auf den Sendeträger einschwingt. Während der Sendephase wird die Phasenregelschleife aufgetrennt, damit der den Träger bereitstellende Oszillator frei weiterläuft und mit einem niederfrequenten Nutzsignal moduliert wird. Das modulierte Oszillatorausgangssignal wird verstärkt und einer Antenne zugeführt. Hierzu wird die Leistungsendstufe während des Sendezeitschlitzes angeschaltet. Während der übrigen Zeit bleibt der Endstufenverstärker abgeschaltet, um Verlustleistung zu sparen und unerwünschte Abstrahlungen zu vermeiden.

Bei den für Mobilfunktechniken üblichen Frequenzlagen im GHz-Bereich sind Leitungsanpassungs- und Abstrahlungserscheinungen nicht mehr vernachlässigbar. Um die sich durch das Anund Abschalten der Leistungsendstufe ergebenden Impedanzänderungen vom Phasenregelkreis abzukoppeln, ist ein Puffer erforderlich. Der Puffer sorgt für eine hohe Rückwärtsisolation zwischen dem Eingang der geschalteten Sendeendstufe und dem Oszillator des Phasenregelkreises, so daß eine Frequenzbeeinflussung des freilaufenden Oszillators aufgrund des Lastwechsels beim Zuschalten der Endstufe relativ gering bleibt.

Der Phasenregelkreis ist teilweise in einer integrierten Schaltung realisiert, wobei das Schleifenfilter außerhalb dieser integrierten Schaltung angeordnet ist. Der Trennverstärker ist aus diskreten Bauelementen aufgebaut. Durch die räumliche Trennung der Komponenten aufgrund der diskreten Realisierung wird erreicht, daß die Einwirkung von Hochfrequenzabstrahlung der Anschlüsse des diskreten Trennverstärkers auf den Eingang des Oszillator des Phasenregelkreises gering bleibt, so daß Frequenzabweichungen des Oszillators dementsprechend gering sind. Eine derartige Lösung ist beispielsweise im Datenblatt "LMX 3160 Single Chip Radio Transceiver" von National Semiconductor, August 1995, insbesondere auf Seite 13 gezeigt. Nachteilig ist jedoch der geringe Integrationsgrad der Lösung aufgrund der externen, diskreten Realisierung des Trennverstärkers.

In der DE 195 02 111 A1 ist ein Sendeempfänger für TDMA-Betrieb beschrieben, der eine Phasenregelschleife enthält, deren Regelkreis unmittelbar vor einem der Sende- und Empfangszeitschlitze geschlossen ist und während des jeweiligen Zeitschlitzes geöffnet ist. Außerdem ist ein Sendeempfänger mit einem VCO-Oszillator beschrieben, dessen Ausgangssignal über einen ersten Verstärker und weitere von einem Sendesteuersignal gesteuerte Verstärker an eine Sende-Empfangs-Antenne abgegeben wird.

Die Aufgabe der Erfindung besteht darin, für eine eingangs genannte Sende- und Empfangsanordnung eine höher integrierte Lösung anzugeben, bei der die Beeinflussung des Oszillators möglichst gering ist.

Erfindungsgemäß wird diese Aufgabe durch eine Sende- und Empfangsanordnung gemäß den Merkmalen des Patentanspruchs 1 gelöst.

Wesentlich bei der erfindungsgemäßen Lösung ist, daß der Trennverstärker in einer zweiten integrierten Schaltung vorgesehen ist, die den Empfangskanal enthält. Wegen der räumlichen Trennung dieser integrierten Schaltung von der ersten integrierten Schaltung, die den Oszillator enthält, ist mit geringer Rückwirkung der Hochfrequenzabstrahlung der Anschlüsse des Trennverstärkers der zweiten integrierten Schaltung auf den Eingang des Oszillators in der ersten integrierten Schaltung zu rechnen. Darüber hinaus kann über die zweite integrierte Schaltung hinweg eine differentielle Schaltungstechnik beibehalten werden, die verglichen mit einer diskreten Lösung zu einer erhöhten Isolation führt. Hierzu wird in vorteilhafter Weise die ohnehin vorhandene Gehäuseisolation ausgenutzt.

Im Gegensatz dazu würde eine Integration des Trennverstärkers beispielsweise auf dem Chip LMX 3160 unbrauchbare Ergebnisse liefern, da der Trennverstärker zusammen mit der Sendeeinrichtung in einem Chip und in einem Gehäuse enthalten wäre, so daß aufgrund der räumlichen Nähe des Trennverstärkers zum Oszillatoreingang eine relativ hohe Hochfrequenzeinwirkung zu erwarten wäre.

Darüber hinaus hat die Integration des Trennverstärkers im Empfangschip den Vorteil, daß das Ausgangssignal der ersten integrierten Schaltung zur Abwärtsmischung des empfangenen Signals bereits chipintern zur Verfügung steht. Dabei weist das Signal unterschiedliche Trägerfrequenz für Sende- und Empfangszeitschlitze auf. Es ist somit nur eine Ausgangsstufe erforderlich, Anschlußpins werden gespart.

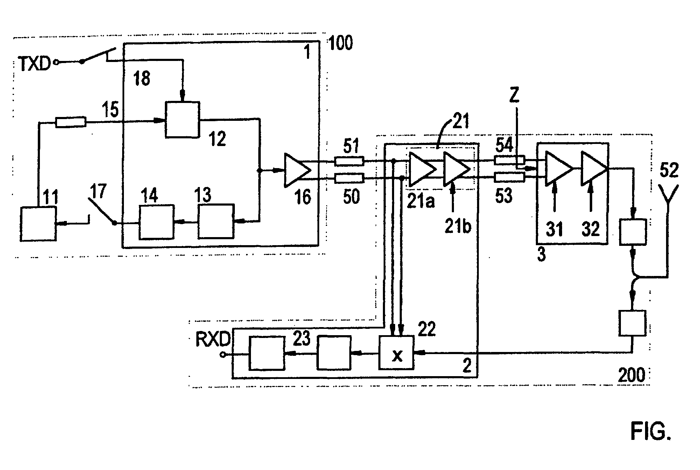

Nachfolgend wird die Erfindung anhand des in der Zeichnung dargestellten Ausführungsbeispiels näher beschrieben. Die einzige Figur zeigt eine erste integrierte Schaltung 1 zur Aufbereitung des Sendesignals, eine zweite integrierte Schaltung 2 mit dem Empfangskanal und dem Trennverstärker 21 und eine Halbleiterschaltung 3 mit Endstufenverstärkern. Die Schaltung 1 enthält die wesentlichen Teile eines Phasenregelkreises auf dem integrierten Schaltungschip. Hierzu gehört ein spannungsgesteuerter Oszillator 12, ein Teiler 13 sowie ein Phasendetektor 14. Das Ausgangssignal des Oszillators 12 wird über den Teiler 13 in den Phasendetektor 14 eingekoppelt wird. Dort erfolgt ein Vergleich mit einer Referenzfrequenz FR, um eine Regelabweichung zu bilden. Diese wird über ein Schleifenfilter 11 an den Steuereingang 15 des Oszillators 12 rückgekoppelt. Das Schleifenfilter 11 ist im Vergleich zu den übrigen Elementen des Phasenregelkreises chipextern angeordnet. Das Ausgangssignal des Oszillators 12 wird außerdem in einem Verstärker 16 zu einem differentiellen Signal gewandelt, d.h. die vom Verstärker 16 abgehenden Leitungen 50, 51 führen zueinander gegenphasige Signale. Die Leitungen 50, 51 werden in einen Trennverstärker 21 eingespeist. Dieser ist im integrierten Schaltkreis 2 des Empfangskanals realisiert. Der Trennverstärker 21 speist ausgangsseitig die Leistungsendstufe 3, die einen Puffer 31 enthält, der eine Umwandlung des differentiellen Signals in ein einphasiges Signal durchführt, und einen Leistungsverstärker 32. Dessen Ausgangssignal wird nach geeigneter Tiefpaßfilterung über eine Sende-Empfangs-Antenne 52 abgestrahlt.

Die Anordnung arbeitet nach einem Zeitschlitzverfahren. Dies bedeutet, daß Senden oder Empfangen nur während je eines Zeitschlitzes möglich ist, wobei verschiedene Zeitschlitze zueinander zeitlich beabstandet sind. Einige Zeit vor einem Zeitschlitz, in dem die Anordnung sendeberechtigt ist, wird der Phasenregelkreis in seinen eingeschwungenen Zustand gebracht, so daß der Sendeträger stabil vorliegt. Währenddessen ist der Schalter 17 zwischen Phasendetektor 14 und Schleifenfilter 11 geschlossen und der Phasenregelkreis weist eine geschlossene Regelschleife aus den Elementen 12, 13, 14 und 11 auf. Unmittelbar vor dem Zeitschlitz wird der Schalter 17 geöffnet, so daß der eingeschwungene Oszillator 12 freiläuft. Über einen weiteren Steuereingang des Oszillators 12, wird dessen Hochfrequenzsignal mit einem Datensignal TXD moduliert. Das Datensignal TXD weist eine im Vergleich zur momentanen Schwingfrequenz des Oszillators 12 wesentlich niedrigere Frequenz auf. Hierzu ist während der Modulationsphase ein Schalter 18 am diesbezüglichen Eingang des Oszillators 12 geschlossen, um die Daten TXD zuzuführen.

Die Endstufentreiber 31, 32 werden nur während eines Sendezeitschlitzes eingeschaltet, um während der übrigen Zeit Verlustleistung zu sparen. Die Eingangsimpedanz Z der Schaltung 3 verändert sich durch das Einschalten erheblich. Damit diese Lastimpedanzänderungen nicht auf den Phasenregelkreis in der integrierten Schaltung 1 rückwirkt, ist der Trennverstärker 21 vorgesehen. Die Hochfrequenzabstrahlung der Ausgangsanschlüsse 53, 54 des Trennverstärkers 21, die durch die jeweiligen äußeren Gehäusepins sowie der inneren Bonddrähte und die außerhalb angeschlossenen Verbindungsleitungen zum Leistungsverstärker bewirkt wird, ist bei Mobilfunkfrequenzen im Bereich von nahezu 1,9 GHz nicht vernachlässigbar. Diese Abstrahlung kann auf die Eingänge des Trennverstärkers 21 zurückwirken sowie auf den Steuereingangsanschluß 15 des Oszillators 12.

Durch die erfindungsgemäße Anordnung werden diese Rückkopplungen jedoch weitgehend gedämpft. Zum einen sind die Schaltungen 1, 2 in jeweils eigenen, getrennten metallischen Abschirmungsgehäusen 100 bzw. 200 angeordnet. Die Abschirmung 200 kann auch die Endstufe und antennenseitigen Filter enthalten. Außerdem sind die Schaltungen 1, 2 räumlich relativ weit voneinander getrennt. Die Rückkopplung der Ausgänge des Trennverstärkers 21 auf den Eingang 15 des Oszillators 12 ist damit weitgehend gedämpft, wodurch eine Frequenzabweichung des Oszillators von der vorgegebenen Sendefrequenz vermieden wird.

Die für den Trennverstärker 21 vorgesehenen Ausgangspins des Gehäuses der integrierten Schaltung 2 und dessen Eingangspins sind vorzugsweise an gegenüberliegenden Gehäuseseiten angeordnet. Sie sind damit möglichst weit voneinander beabstandet. Bei der Rückkopplung der Ausgänge des Verstärkers 21 auf seine Eingänge sorgt bedingt durch deren beabstandete Anordnung am Gehäuse und die differentielle Schaltungstechnik die Isolation des Schaltungsgehäuses für Dämpfung. Im Vergleich zu der diskreten Realisierung nach dem Stand der Technik ist die Gehäuseisolation wegen der differentiellen Schaltungstechnik erhöht. Dies ist dadurch bedingt, daß sich die im Abstand der Eingangs-/Ausgangspins bereits wirkenden differentiellen Fernfelder der Abstrahlung in gewissem Maße kompensieren. Demgegenüber ist die Rückwirkung innerhalb des integrierten Schaltungschips wesentlich geringer und tritt gegenüber der externen Rückkopplung in den Hintergrund. Vorzugsweise umfaßt der Trennverstärker 21 zwei signalmäßig hintereinander geschaltete Einzelverstärker 21a und 21b. Einer der Verstärker, zweckmäßigerweise der nachgeschaltete Verstärker 21b ist abschaltbar, um Verlustleistung zu sparen.

Der Empfangsbaustein 2 enthält außer dem oben beschriebenen Trennverstärker 21, der im Sendepfad wirkt, die Signalverarbeitungseinrichtungen für den Empfangskanal. Ein über die Sende-Empfangs-Antenne 52 eingekoppeltes hochfrequentes Signal wird nach Bandpaßfiltermaßnahmen in einen Mischer 22 eingekoppelt. Diesem werden außerdem die am verstärkereingang des Trennverstärkers 21 anliegenden Signale zugeführt. Der Mischer 22 führt eine Abwärtsmischung des empfangenen Signals durch. Nach einer Demodulationseinrichtung 23 liegen die empfangenen digitalen Daten RXD ausgangsseitig vor.

## Patentansprüche

1. Sende- und Empfangsanordnung für Hochfrequenzsignale, umfassend einen Phasenregelkreis, dessen Rückkopplungsschleife (12, 13, 14, 11) auftrennbar ist und der einen steuerbaren Oszillator (12) enthält, und einen Leistungsverstärker (31, 32), der eingangsseitig mit einem Ausgang des Oszillators (12) gekoppelt ist, wenn die Rückkopplungsschleife (12, 13, 14, 11) des Phasenregelkreises aufgetrennt ist, und an dem ausgangsseitig ein Hochfrequenzsignal zur Kopplung an eine Signalabgabeeinrichtung (52) abgreifbar ist, wobei der Phasenregelkreis teilweise in einer ersten integrierten Schaltung (1) angeordnet ist,
**gekennzeichnet durch**
eine zweite integrierte Schaltung (2), die Schaltungsmittel (22, 23) zur Abwärtsmischung eines von einer Signalempfangseinrichtung (52) bereitgestellten anderen Hochfrequenzsignals enthält sowie einen Trennverstärker (21).

2. Anordnung nach Anspruch 1,
**dadurch gekennzeichnet, daß**
die integrierten Schaltungen (1, 2) von je einem Gehäuse umgeben sind.

3. Anordnung nach Anspruch 2,
**dadurch gekennzeichnet, daß**
die integrierten Schaltungen (1, 2) einschließlich der jeweiligen Gehäuse von je einer Abschirmung (100, 200) umgeben sind.

4. Anordnung nach einem der Ansprüche 1 bis 3,
**dadurch gekennzeichnet, daß**
der Phasenregelkreis umfaßt: den steuerbaren Oszillator (12), der frequenzsteuerbar ist, einen mit dem Ausgang des Oszillators (12) verbundenen Teiler (13), einen mit dem Teiler (13) verbundenen Phasendetektor (14), dem außerdem ein Referenzfrequenzsignal (FR) zuführbar ist, und ein Schleifenfilter (11), über das der Phasendetektor (14) mit einem Steuereingang des Oszillators (12) zur Frequenzsteuerung verbunden ist, wobei der Oszillator (12), der Teiler (13) und der Phasendetektor (14) in der ersten integrierten Schaltung (1) angeordnet sind und das Schleifenfilter (11) außerhalb davon, und daß Schaltmittel (17) vorgesehen sind, durch die die Rückkopplungsschleife (12, 13, 14, 11) des Phasenregelkreises nach dem Kopplungknoten des Oszillatorausgangs mit dem Leistungsverstärker (31, 32) und vor dem schleifenfilterseitigen Eingang des Oszillators (12) unterbrechbar ist.

5. Anordnung nach einem der Ansprüche 1 bis 4,
**dadurch gekennzeichnet, daß**
der Oszillator (12) einen Steuereingang aufweist, an dem ein niederfrequentes Modulationssignal (TXD) zur Frequenzmodulation des Oszillators (12) einkoppelbar ist, wenn die Rückkopplungsschleife (12, 13, 14, 11) aufgetrennt ist.

6. Anordnung nach einem der Ansprüche 1 bis 5,
**dadurch gekennzeichnet, daß**
der Trennverstärker (21) eine erste Verstärkereinrichtung (21a) umfaßt und eine zweite, dieser nachgeschaltete Verstärkereinrichtung (21b), die abschaltbar ist.

7. Anordnung nach einem der Ansprüche 1 bis 6,
**dadurch gekennzeichnet, daß**
das von der ersten integrierten Schaltung (1) abgegebene Hochfrequenzsignal in die zweite integrierte Schaltung (2) differentiell eingespeist wird außerdem differentiell an den Leistungsverstärker (31, 32) abgegeben wird.

## Claims

1. Transceiver arrangement for radio frequency signals, comprising a phase-locked loop whose feedback loop (12, 13, 14, 11) can be disconnected and which contains a controllable oscillator (12), and a power amplifier (31, 32) which is coupled at the input end to an output of the oscillator (12) when the feedback loop (12, 13, 14, 11) of the phase-locked loop is disconnected, and at which a radio frequency signal for coupling to a signal output device (52) can be tapped at the output end, the phase-locked loop being partially arranged in a first integrated circuit (1), **characterized by** a second integrated circuit (2) which contains switching means (22, 23) for down-mixing another radio frequency signal which is made available by a signal reception device (52), and an isolating amplifier (21).

2. Arrangement according to Claim 1, **characterized in that** the integrated circuits (1, 2) are each surrounded by a housing.

3. Arrangement according to Claim 2, **characterized in that** the integrated circuits (1, 2), including the respective housings, are each surrounded by a screening element (100, 200).

4. Arrangement according to one of Claims 1 to 3, **characterized in that** the phase-locked loop comprises: the controllable oscillator (12) which is frequency-controlled, a divider (13) which is connected to the output of the oscillator (12), a phase detector (14) which is connected to the divider (13) and to which a reference frequency signal (FR) can also be fed, and a loop filter (11) via which the phase detector (14) is connected to a control input of the oscillator (12) in order to control the frequency, the oscillator (12), the divider (13) and the phase detector (14) being arranged in the first integrated circuit (1) and the loop filter (11) being arranged outside it, and **in that** switching means (17) are provided by means of which the feedback loop (12, 13, 14, 11) of the phase-locked loop can be disconnected downstream of the coupling node of the oscillator output to the power amplifier (31, 32), and upstream of the loop-filter-end input of the oscillator (12).

5. Arrangement according to one of Claims 1 to 4, **characterized in that** the oscillator (12) has a control input to which a low-frequency modulation signal (TXD) can be coupled in order to modulate the frequency of the oscillator (12) when the feedback loop (12, 13, 14, 11) is disconnected.

6. Arrangement according to one of Claims 1 to 5, **characterized in that** the isolating amplifier (21) comprises a first amplifier device (21a) and a second amplifier device (21b) which is connected downstream thereof and can be switched off.

7. Arrangement according to one of Claims 1 to 6, **characterized in that** the radio frequency signal which is output by the first integrated circuit (1) is fed into the second integrated circuit (2) in a differential fashion, and is also output to the power amplifier (31, 32) in a differential fashion.

## Revendications

1. Dispositif d'émission et de réception pour des signaux à haute fréquence, comprenant un circuit de régulation de phase, dont la boucle de rétroaction (12, 13, 14, 11) est séparable et contient un oscillateur commandable (12), et un amplificateur de puissance (31, 32), qui est couplé côté entrée à une sortie de l'oscillateur (12), lorsque la boucle de rétroaction (12, 13, 14, 11) du circuit de régulation de phase est séparée et sur le côté sortie duquel peut être prélevé un signal à haute fréquence destiné à être couplé à un dispositif (52) de délivrance de signaux, le circuit de régulation de phase étant disposé en partie dans un premier circuit intégré (1),
**caractérisé par**
un second circuit intégré (2), qui contient des moyens de circuit (22, 23) pour mélange aval d'un signal à haute fréquence préparé par un dispositif de réception de signaux (52), ainsi qu'un amplificateur de séparation (21).

2. Dispositif selon la revendication 1, **caractérisé en ce que** les circuits intégrés (1, 2) sont entourés chacun par un boîtier.

3. Dispositif selon la revendication 2, **caractérisé en ce que** les circuits intégrés (1, 2) y compris le boîtier respectif sont entourés par un blindage respectif (100, 200).

4. Dispositif selon l'une des revendications précédentes, **caractérisé en ce que** le circuit de régulation de phase comprend: l'oscillateur commandable (12), dont la fréquence peut être commandée, un diviseur (13) relié à la sortie de l'oscillateur (12), un détecteur de phase (14) relié au diviseur (13) et auquel peut être envoyé un signal de fréquence de référence (FR), et un filtre de boucle (11), au moyen duquel le détecteur de phase (14) est relié à une entrée de commande de l'oscillateur (12) pour la commande de fréquence, l'oscillateur (12), le diviseur (13) et le détecteur de phase (14) étant disposés dans le premier circuit intégré (1), et le filtre de boucle (11) étant disposé entre les circuits, et **en ce que** des moyens de commutation (17) sont prévus, à l'aide desquels les boucles de rétroaction (12, 13, 14, 11) du circuit de régulation de phase peuvent être interrompues en aval du noeud de couplage de la sortie d'oscillateur avec l'amplificateur de puissance (31, 32) et en amont de l'entrée, située du côté du filtre de boucle, de l'oscillateur (12).

5. Dispositif selon l'une des revendications 1 à 4, **caractérisé en ce que** l'oscillateur (12) comporte une entrée de commande, à laquelle peut être envoyé un signal de modulation à basse fréquence (TXD) pour réaliser la modulation de fréquence de l'oscillateur (12), lorsque la boucle de rétroaction (12, 13, 14, 11) est séparée.

6. Dispositif selon l'une des revendications 1 à 5, **caractérisé en ce que** l'amplificateur de séparation (21) comporte un premier dispositif d'amplification (21a) et un second dispositif d'amplification (21b) branché en aval et qui peut être débranché.

7. Dispositif selon l'une des revendications 1 à 6, **caractérisé en ce que** le signal à haute fréquence délivré par le premier circuit intégré (1) est introduit de façon différentielle dans le second circuit intégré (2), et en outre est délivré de façon différentielle à l'amplificateur de puissance (31, 32).
